# FASCICULE DE BREVET EUROPEEN

(11) **EP 3 245 560 B1**
(45) Date de publication et mention de la délivrance du brevet: **16.11.2022**
(21) Numéro de dépôt: 16703567.4
(22) Date de dépôt: 11.01.2016
(51) Int. Cl.: G03B 21/00, H04N 9/31, G02B 27/10, G02B 5/10

(54) **SOURCE DE LUMIÈRE À DIODES POUR UN PROJECTEUR.**
DIODENLICHTQUELLE FÜR EINEN PROJEKTOR
DIODE LIGHT SOURCE FOR A PROJECTOR

(30) Priorité: 12.01.2015 FR 1550208
(43) Date de publication de la demande: 22.11.2017
(60) Demande divisionnaire: 22194770.8
(73) Titulaire: Xyzed, 75018 Paris (FR)
(72) Inventeur: REBIFFE, Maurice, 75018 Paris (FR); FERRANDON, Jean Pierre, 91380 Chilly Mazarin (FR)
(74) Mandataire: Cabinet Beau de Loménie
(86) Numéro de dépôt international: PCT/FR2016/050040
(87) Numéro de publication internationale: WO 2016/113490

(56) Documents cités:
- EP-A1- 0 717 476
- JP-A- 2007 047 245
- US-A1- 2006 164 600
- Anonyme: "Cinemeccanica France - Cinecloud(TM) Lux the smart cinema laser", Site web de Cinemeccanica France , 2 décembre 2014 (2014-12-02), XP055233411, Extrait de l'Internet: URL:https://web.archive.org/web/2014120219 1832/http://www.cinemeccanica.fr/cin%C3%A9 ma/cinecloud-lux-the-smart-cinema-laser/ [extrait le 2015-12-03]

## Description

### Domaine de l'invention

La présente invention se rapporte au domaine de l'éclairage et elle concerne plus particulièrement une source de lumière blanche pour projecteurs cinéma ou vidéo à diodes électroluminescentes ou lasers.

### Art antérieur

Jusqu'à récemment, les projecteurs étaient classiquement constitués d'une lampe à incandescence ou d'une lampe à décharge type Xenon, HMI ou HTI, et d'un réflecteur pour focaliser le faisceau lumineux issu de cette lampe vers un système optique comportant une ou plusieurs lentilles disposées dans le faisceau lumineux. Dans les projecteurs de scène ou de spectacle, différents obturateurs sont aussi placés en sortie du système optique pour assurer la réalisation d'effets spéciaux, par exemple un couteau de découpe, une roue de couleur, un iris et une roue de gobos.

Toutefois, depuis quelques années sont apparus sur le marché de l'éclairage, notamment cinéma et vidéo, des projecteurs dont les sources de lumière, destinées à remplacer ces lampes à décharge ou à incandescence, sont des LEDs ou des diodes lasers, comme dans le brevet US6,224,216. Malheureusement, ces projecteurs sont pénalisés par une taille importante des sources de lumière due essentiellement au nombre très élevé de fibres optiques utilisées pour collecter la lumière. Ce grand nombre de fibres optiques résulte en effet de la difficulté à collimater les faisceaux des diodes en un seul point de focalisation pour permettre de concentrer la lumière dans une unique fibre optique de sortie dont le diamètre courant est de l'ordre de 400 à 1500µm et l'ouverture numérique standard de l'ordre de 0,22 jusqu'à de préférence 0,37. De plus, la gestion des diodes montées en série s'effectue en nombre réduit, souvent par des séries de 6 à 12 diodes maximum et ces séries de diodes sont généralement regroupées par couleur (Rouge, Vert, Bleu), chacune de ces couleurs étant reliée à une fibre optique différente. Ainsi, chaque module RVB connecté à une carte de gestion doit être relié à une fibre, ce qui ne permet pas aisément de multiplier le nombre de modules pour obtenir une grande puissance d'éclairage (typiquement supérieur à 30 watts) dans un volume réduit, d'accès facile, et surtout permettant un assemblage aisé pour la fabrication comme pour la maintenance. US2006/164600, EP0717476 et JP2007047245 sont des exemples de sources de lumière.

### Objet et définition de l'invention

La présente invention propose de s'affranchir de cette contrainte avec un projecteur d'éclairage dont la source de lumière peut être simplifiée considérablement. Un but de l'invention est d'obtenir une source de lumière particulièrement compacte mais permettant malgré tout de délivrer une grande puissance d'éclairage supérieure à 30 watts et pouvant aller jusqu'à plus de 100 watts

Ces buts sont atteints par une source de lumière blanche à diodes lasers selon la revendication indépendante.

Ainsi, en supprimant l'ensemble des fibres optiques de collimation par couleur et en renvoyant, par un jeu de lames dichroïques, sur un unique miroir parabolique hors axe les différents faisceaux de lumière issus des diodes RGB , il devient possible de concentrer tous ces faisceaux en un seul point focal déterminé en entrée d'une seule fibre optique permettant la conduite de la lumière et où les trois couleurs primaires se retrouvent alors mixées.

Les revendications dépendantes définissent des modes de réalisation avantageux.

L'invention concerne également un projecteur d'éclairage comportant au moins une source de lumière blanche à diodes telle que précitée.

### Brève description des dessins

Les caractéristiques et avantages de la présente invention ressortiront mieux de la description suivante, faite à titre indicatif et non limitatif, en regard des dessins annexés sur lesquels :
- la figure 1 est une vue partielle de dessus d'un projecteur selon l'invention,
- la figure 2 est une vue en perspective d'un module d'éclairage à diodes du projecteur de la figure 1, et
- la figure 3 illustre schématiquement le cheminement des faisceaux de lumière dans un exemple de projecteur non couvert par le texte des revendications.

### Description détaillée d'un mode de réalisation préférentiel

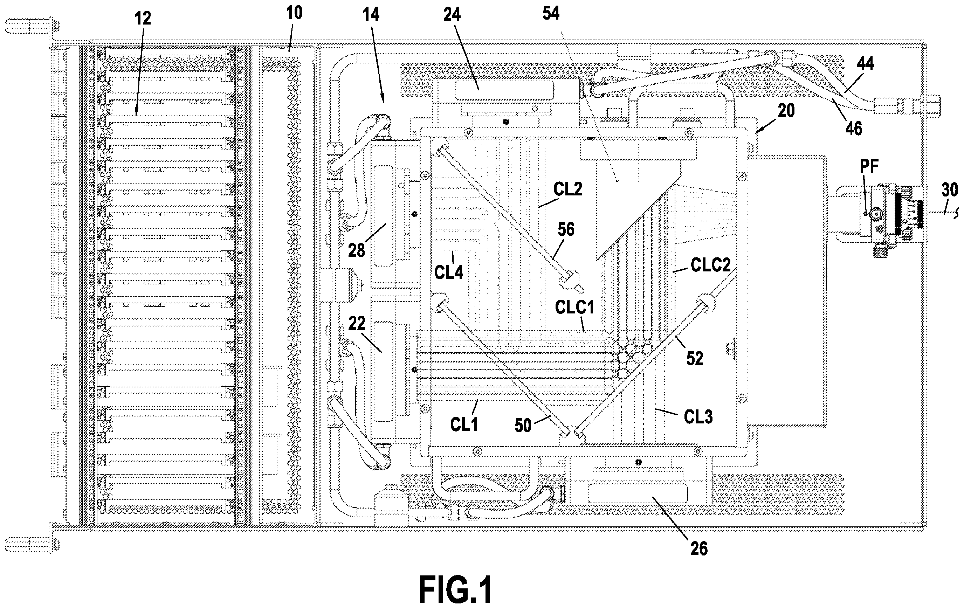

La figure 1 illustre une source de lumière à diodes conforme à l'invention destinée à être montée dans un châssis d'alimentation standard de type « rack 2U, 3U ou 4U » (c'est-à-dire pouvant être monté directement dans une baie standard 19 pouces). Ce châssis 10 comporte une partie électronique 12 destinée à recevoir le différentes cartes de gestion des diodes et une partie optique 14 destinée à recevoir la source de lumière proprement dite et y compris ses moyens de dissipation de la chaleur dégagée par les diodes.

Selon l'invention, la source de lumière 20 est une source de lumière de grande puissance et très compacte élaborée à partir de trois modules d'éclairage à diodes lasers 22, 24, 26 disposés à 90° les uns des autres et d'un système optique permettant la collimation et la focalisation des faisceaux lumineux issus de ces modules dans une unique fibre optique de sortie. Toutefois, pour un meilleur équilibrage des couleurs, la source de lumière est préférentiellement mais pas obligatoirement constituée à partir de quatre modules de diodes lasers, le quatrième module 28 étant alors disposé avantageusement dans l'axe de la fibre optique de sortie 30.

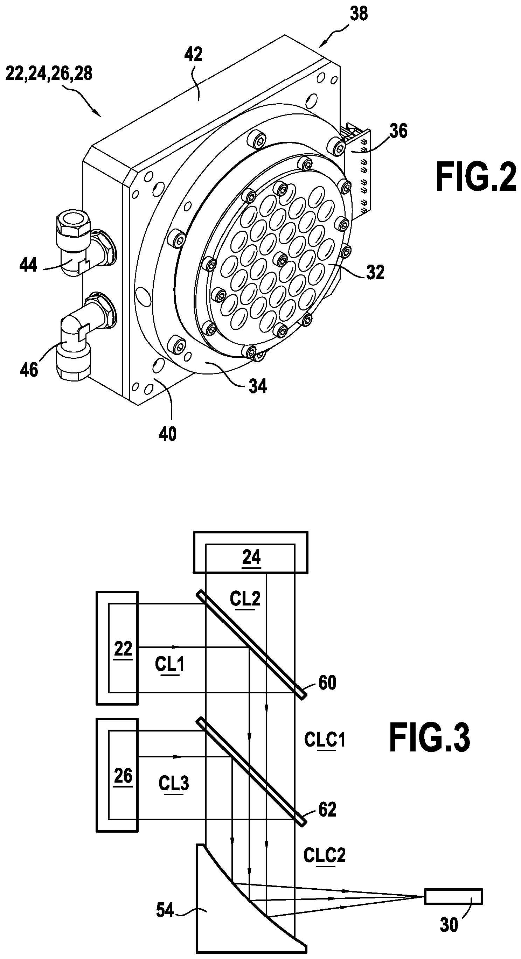

Comme le montre la figure 2, chaque module de diodes laser comporte un grand nombre de diodes lasers 32 d'une même longueur d'onde, réparties régulièrement en forme de matrice (32 diodes sur cette figure correspondant à des diodes vertes et typiquement de 12 à 60 dont la puissance est variable selon le type et la technologie employés) et montées sur une plaque support 34, chaque diode étant surmontée d'une lentille plastique ou de verre de très petite taille portée par un élément de centrage (tous deux non représentés), de façon à produire un nombre correspondant de faisceau lumineux parallèles, l'ensemble de ces faisceaux formant en quelque sorte un conduit de lumière CL de la couleur associée à la longueur d'onde des diodes de la matrice. On notera que ces diodes pourraient aussi être des diodes RGB dont seule l'une des couleurs est activée, l'anode correspondant à la couleur sélectionnée étant alors la seule connectée.

La plaque support 34 incorpore des pistes conductrices (non représentées) reliées à des bornes d'alimentation en courant 36 et elle est directement en contact de moyens 38 de dissipation de la chaleur dégagée par la matrice de diodes. Ces moyens de dissipation de chaleur qui sont décrits plus en détail dans la demande déposée le même jour et intitulée « module d'éclairage à diodes à refroidissement amélioré » comportent une plaque métallique de jonction 40 dont une face externe est en contact direct avec la plaque support et une face interne supporte une mousse métallique alvéolaire contenue dans un boitier 42 ayant la forme d'une cuve cloisonnée, étanche à un fluide de refroidissement, avantageusement de l'eau en phase liquide ou de l'eau glycolée, et dont la plaque métallique de jonction 40 constitue le couvercle. Ce fluide de refroidissement est respectivement véhiculé vers et depuis les modules de diodes par des canalisations aller 44 et retour 46.

Revenons à la figure 1. La source de lumière à diodes illustrée comporte quatre modules de diodes lasers aptes à former quatre conduits de lumière séparés à partir des faisceaux lumineux parallèles de chacune des diodes de ces quatre modules. Chaque module délivre une couleur déterminée par la longueur d'onde des diodes identiques qui le compose et les dimensions du conduit de lumière déterminées par la dimension de la matrice et donc le nombre de ces diodes. Plus particulièrement, pour la création d'une lumière blanche, une première lame dichroïque 50 disposée à 45° laisse passer au travers d'elle un premier conduit de lumière CL1 d'une première longueur d'onde (typiquement de 430 à 460 nm) correspondant à la couleur bleu primaire issu du premier module à diodes lasers 22 et réfléchit un deuxième conduit de lumière CL2 d'une deuxième longueur d'onde (typiquement de 620 à 650 nm) correspondant à la couleur rouge primaire issu du deuxième module à diodes lasers 24 pour former un premier conduit de lumière combinée CLC1 transportant les couleurs bleu et rouge. Une structure de filtre passe-bas à fréquence de coupure de l'ordre de 470nm conviendra bien pour une telle première lame dichroïque. De même, une deuxième lame dichroïque 52 disposée aussi à 45° mais perpendiculairement, laisse passer au travers d'elle un troisième conduit de lumière CL3 d'une troisième longueur d'onde (typiquement de 510 à 530 nm) correspondant à la couleur verte primaire issu du troisième module à diodes lasers 26 et réfléchit le premier conduit de lumière combinée pour former un second conduit de lumière combinée CLC2 transportant alors les trois couleurs primaires vers un miroir parabolique hors axe 54 disposé en travers de ce conduit de lumière combinée pour le réfléchir et le focaliser en un point focal déterminé PF en entrée de l'unique fibre optique de sortie 30. Une structure de filtre passe-bande à fréquences de coupure basse et haute de l'ordre de 500 et 540nm conviendra bien pour une telle deuxième lame dichroïque.

Selon un exemple préférentiel de réalisation, la source de lumière à diodes comporte quatre modules à diodes lasers et il est donc prévu un troisième séparateur constitué d'un filtre polarisant 56 disposé en travers (c'est-à-dire faisant un angle de 45° avec l'axe central du conduit) du deuxième conduit de lumière CL2 transportant la lumière rouge primaire et donc le laissant passer au travers d'elle mais aussi réfléchissant un quatrième conduit de lumière CL4 de la deuxième longueur d'onde correspondant donc aussi à la couleur rouge primaire pour former un conduit de lumière combinée ne comportant toutefois que cette couleur rouge primaire à destination de la première lame dichroïque 50. L'adjonction d'un second module de lumière rouge permet par un meilleur équilibrage des couleurs d'obtenir un blanc par synthèse additive des couleurs rouge, verte et bleu. En effet, les diodes rouges sont aujourd'hui de moindre puissance que les diodes vertes ou bleues de sorte que la combinaison d'un nombre équivalent de diodes de chaque couleur ne permet pas d'obtenir une lumière blanche de bonne qualité (notamment pour répondre aux normes DCI) d'où la nécessité de recourir à un module à diodes rouges supplémentaire pour permettre un meilleur équilibrage.

Bien entendu, il est clair que selon le type des diodes mises en jeu, ce module supplémentaire pourrait être d'une autre couleur que la couleur rouge, comme il pourrait aussi ne pas être présent (voir la figure 3).

On notera qu'en disposant les trois premiers modules à diodes lasers à 90° les uns des autres, il est possible d'obtenir une configuration en carré du système optique particulièrement compacte et donc pouvant être installée sans difficulté dans des racks normalisés de type 2U à 4U, les première 50 et deuxième 52 lames dichroïques disposées elles-mêmes à 90° l'une de l'autre et le filtre polarisant 56 parallèlement à la première, occupant chacune un quadrant de ce carré, le miroir parabolique 54 occupant le dernier.

Le schéma simplifié de la figure 3 illustre un autre exemple de réalisation de la source de lumière non couvert par le texte des revendications et donné seulement à titre illustratif, dans lequel la première lame dichroïque présente une structure de filtre passe-haut avec une fréquence de coupure de l'ordre de 470nm et la deuxième lame dichroïque une structure de filtre coupe-bande avec des fréquences de coupure basse et haute à 500 et 540nm environ. Dans cette configuration plus compacte (dans un rack au plus 4U, il en effet possible d'installer quatre sources de ce type au lieu de deux du type précédent, l'électronique restant inchangée), la première lame dichroïque 60 disposée à 45° laisse passer au travers d'elle le deuxième conduit de lumière CL2 correspondant à la couleur rouge primaire issu du deuxième module à diodes lasers 24 et réfléchit le premier conduit de lumière CL1 correspondant à la couleur bleu primaire issu du premier module à diodes lasers 22 pour former le premier conduit de lumière combinée CLC1 transportant les couleurs bleu et rouge. De même, la deuxième lame dichroïque 62 disposée parallèlement à la première et donc aussi à 45° laisse passer au travers d'elle le premier conduit de lumière combinée et réfléchit le troisième conduit de lumière CL3 correspondant à la couleur verte primaire issu du troisième module à diodes lasers 26 pour former le second conduit de lumière combinée CLC2 transportant alors les trois couleurs primaires vers le miroir parabolique hors axe 54 disposé en travers de ce second conduit de lumière combinée pour le réfléchir et le focaliser en un point focal déterminé d'entrée de l'unique fibre optique de sortie 30.

## Revendications

1. Source de lumière blanche à diodes lasers pour projecteur comportant :
- au moins des première (22), deuxième (24) et troisième (26) matrices de diodes lasers apte à délivrer respectivement au moins des premier (CL1), deuxième (CL2) et troisième (CL3) conduits de lumière séparés de longueurs d'onde et dimensions déterminées à partir de faisceaux lumineux parallèles de chacune des diodes de ces matrices de diodes,
- une première lame dichroïque (50) apte à former un premier conduit de lumière combinée (CLC1) à partir desdits premier et deuxième conduits de lumière, et configurée pour laisser passer au travers d'elle ledit premier conduit de lumière (CL1) d'une première longueur d'onde délivré par ladite première matrice de diodes lasers (22) et réfléchir ledit deuxième conduit de lumière (CL2) d'une deuxième longueur d'onde délivré par ladite deuxième matrice de diodes lasers (24) pour former ledit premier conduit de lumière combinée (CLC1), et
- une deuxième lame dichroïque (52) apte à former un second conduit de lumière combinée (CLC2) à partir dudit premier conduit de lumière combinée et dudit troisième conduit de lumière, et configurée pour laisser passer au travers d'elle ledit troisième conduit de lumière (CL3) d'une troisième longueur d'onde délivré par ladite troisième matrice de diodes lasers (26) et réfléchir ledit premier conduit de lumière combinée (CLC1) pour former ledit second conduit de lumière combinée (CLC2),
**caractérisée en ce qu'**elle comporte en outre :
- un miroir parabolique hors axe (54) pour recevoir ledit second conduit de lumière combinée et le focaliser en un point focal déterminé correspondant à un point d'entrée pour une unique fibre optique (30), et
- un filtre polarisant (56) configuré pour laisser passer au travers de lui ledit deuxième conduit de lumière (CL2) de ladite deuxième longueur d'onde et réfléchir un quatrième conduit de lumière (CL4) de ladite deuxième longueur d'onde délivré par une quatrième matrice de diodes lasers (28) pour former un conduit de lumière combinée à destination de ladite première lame dichroïque.

2. Source de lumière blanche à diodes lasers selon la revendication 1, dans laquelle ladite deuxième lame dichroïque (52) est disposée perpendiculairement à ladite première lame dichroïque, chacune desdites lames dichroïques (50, 52) étant en outre disposée à 45° par rapport aux dits conduits de lumière.

3. Source de lumière blanche à diodes lasers selon la revendication 1, dans laquelle lesdites première, deuxième et troisième longueurs d'onde correspondent respectivement aux couleurs primaires bleu, rouge et verte.

4. Projecteur d'éclairage comportant au moins une source de lumière blanche à diodes lasers selon la revendication 3.

## Patentansprüche

1. Laserdioden-Weißlichtquelle für einen Projektor, umfassend:
- mindestens erste (22), zweite (24) und dritte (26) Laserdiodenanordnungen, die dazu geeignet sind, jeweils mindestens erste (CL1), zweite (CL2) und dritte (CL3) getrennte Lichtleiter mit bestimmten Wellenlängen und Dimensionen aus parallelen Lichtstrahlen jeder der Dioden dieser Diodenanordnungen abzugeben,
- eine erste dichroitische Platte (50), die geeignet ist, einen ersten kombinierten Lichtleiter (CLC1) aus den ersten und zweiten Lichtleitern zu bilden, und die dazu konfiguriert ist, durch diese den ersten Lichtleiter (CL1) mit einer ersten Wellenlänge, der von der ersten Laserdiodenanordnung (22) abgegeben wird, durchzulassen und den zweiten Lichtleiter (CL2) mit einer zweiten Wellenlänge, der von der zweiten Laserdiodenanordnung (24) abgegeben wird, zu reflektieren, um den ersten kombinierten Lichtleiter (CLC1) zu bilden, und
- eine zweite dichroitische Platte (52), die geeignet ist, einen zweiten kombinierten Lichtleiter (CLC2) aus dem ersten kombinierten Lichtleiter und dem dritten Lichtleiter zu bilden, und die dazu konfiguriert ist, durch diese den dritten Lichtleiter (CL3) mit einer dritten Wellenlänge, der von der dritten Laserdiodenanordnung (26) abgegeben wird, durchzulassen und den ersten kombinierten Lichtleiter (CLC1) zu reflektieren, um den zweiten kombinierten Lichtleiter (CLC2) zu bilden, **dadurch gekennzeichnet, dass** sie ferner umfasst:
- einen außeraxialen Parabolspiegel (54), um den kombinierten zweiten Lichtleiter zu empfangen und ihn in einem bestimmten Brennpunkt zu fokussieren, der einem Eintrittspunkt für eine einzige Lichtleitfaser (30) entspricht, und
- ein Polarisationsfilter (56), das dazu konfiguriert ist, durch dieses den zweiten Lichtleiter (CL2) mit der zweiten Wellenlänge durchzulassen und einen vierten Lichtleiter (CL4) mit der zweiten Wellenlänge, der von einer vierten Laserdiodenanordnung (28) abgegeben wird, zu reflektieren, um einen kombinierten Lichtleiter für die erste dichroitische Platte zu bilden.

2. Laserdioden-Weißlichtquelle nach Anspruch 1, wobei die zweite dichroitische Platte (52) zu der ersten dichroitischen Platte rechtwinklig angeordnet ist, wobei jede der dichroitischen Platten (50, 52) ferner um 45° gegenüber den Lichtleitern angeordnet ist.

3. Laserdioden-Weißlichtquelle nach Anspruch 1, wobei die ersten, zweiten und dritten Wellenlängen jeweils den Primärfarben Blau, Rot und Grün entsprechen.

4. Beleuchtungsprojektor, der mindestens eine Laserdioden-Weißlichtquelle nach Anspruch 3 umfasst.

## Claims

1. Laser diode white light source for a projector comprising:
- at least first (22), second (24), and third (26) laser diode matrices suitable for respectively delivering at least first(CL1), second(CL2), and third(CL3) separate light bundles of wavelengths and determined dimensions from parallel light beams of each diode of said diode matrices:
• a first dichroic plate (50) suitable for forming a first combined light bundle (CLC1) from said first and second light bundles, and configured to allow said first light bundle (CL1) of a first wavelength delivered by said first diode matrix (22) to pass therethrough and to reflect said second light bundle (CL2) of a second wavelength delivered by said second diode matrix (24) to form said first combined light bundle (CLC1); and
• a second dichroic plate (52) suitable for forming a second combined light bundle (CLC2) from said first combined light bundle and said third light bundle, and configured to allow said third light bundle (CL3) of a third wavelength delivered by said third diode matrix (26) to pass therethrough and to reflect said first combined light bundle (CLC1) to form said second combined light bundle (CLC2);
**characterized in that** it further comprises:
- an off-axis parabolic mirror (54) for receiving said second combined light bundle and focusing it on a determined focal point corresponding to an inlet point for a single optical fiber (30), and
- a polarizing filter (56) configured to allow said second light bundle (CL2) of said second wavelength to pass therethrough and to reflect a fourth light bundle (CL4) of said second wavelength delivered by a fourth diode matrix (28) to form a combined light bundle going to said first dichroic plate.

2. Laser diode white light source according to claim 1, wherein said second dichroic plate (52) is arranged perpendicularly to said first dichroic plate, each of said dichroic plates (50, 52) also being arranged at 45° relative to said light bundles.

3. Laser diode white light source according to claim 1, wherein said first, second and third wavelengths correspond respectively to the blue, red, and green primary colors.

4. Lighting projector including at least one laser diode white light source according to claim 3.
